# EUROPEAN PATENT SPECIFICATION

(11) **EP 1 629 706 B1**
(45) Date of publication and mention of the grant of the patent: **09.01.2008**
(21) Application number: 04766034.5
(22) Date of filing: 04.06.2004
(51) Int. Cl.: H05K 13/04, H05K 3/30

(54) **METHOD FOR ASSEMBLING A CIRCUIT**
VERFAHREN ZUM ZUSAMMENBAU EINER SCHALTUNG
PROCEDE POUR ASSEMBLER UN CIRCUIT

(30) Priority: 04.06.2003 DE 10325179
(43) Date of publication of application: 01.03.2006
(73) Proprietor: Ericsson AB, Stockholm (SE)
(72) Inventor: MULLER, Ulf, 71522 Backnang (DE); KONRATH, Willibald, 71554 Cottenweiler (DE); SCHOLL, Klaus, 71522 Backnang (DE); SCHMELCHER, Haiko, 74427 Fichtenberg (DE); GORTZEN, Ralf, 71546 Aspach-Rietenau (DE); NAHRING, Martin, 71554 Weissach (DE)
(74) Representative: Stasiewski, Piotr Grzegorz
(86) International application number: PCT/EP2004/051034
(87) International publication number: WO 2004/110126

(56) References cited:
- EP-A- 1 161 129
- DE-A- 19 610 294
- US-A- 4 776 080
- US-A1- 2002 184 755

## Description

The present invention relates to a method for automatically assembling an electronic or optical circuit, in particular a microwave circuit.

Most of the automatic placing devices and methods of the prior art are concerned with distributing a large number of electronic components quickly and reproducibly on a common circuit board Usually, such a circuit board is plain, so that all circuit components have to be placed at the same level.

Such a circuit board is usually provided with one or more reference marks, also called Fiducials, that are intended to be detected by an image recognition system of the placing machine, so that it may, based on the thus detected positions of the reference marks and the control data that indicate the position of the individual circuit components with respect to the reference marks, place these circuit components correctly on the circuit board even if the position of the circuit board in which the placing is carried out does not exactly agree with a desired position (See US-A-2002/0184755).

Optical and electro optical circuits and electronic circuits for high frequency applications often have a complicated mechanical design in which the individual circuit components are distributed onto one or more substrates, which, in term, are placed on a base plate, e.g. a printed circuit board.

The use of conventional placing machines for assembling such circuits is difficult for various reasons. If a circuit is to be built up on the base plate successively from individual components, which here shall comprise in particular the substrates and the electronic/optical/optoelectronic or other types of signal processing circuit components, these components must be placed precisely. If a substrate is placed inaccurately, the path lengths between various substrates on the base plate may differ from a predefined value, whereby the placement of the circuit parts formed on the individual substrates may be impaired. Also, an inaccurately placed substrate causes inaccuracies of placement of all components subsequently mounted on it. If the substrate is displaced into a first direction from its desired position, all components placed on the substrate have a systematic displacement with respect to the substrate which is inversely equal to the displacement of the substrate with respect to the base plate.

It might be envisioned that this problem be to handled in several steps. Firstly, placing circuit components on the substrates, and afterwards, eventually also by automatic placement, to place the thus obtained hybrid elements on the base plate. However, such a solution is very time consuming, because if a number n of hybrid elements is to be mounted on a base plate, this requires n+1 placing operations, in each of which a support which is to receive components and which may be a substrate or the base plate, has to be positioned exactly at the placing machine and must be removed after placing. The high number of positioning and placing operations requires considerable time. Moreover, such a procedure requires that all hybrid elements must be finished before starting to mount them on the base plate. The finished hybrids must be stacked for some time, which requires administrative effort. Since it is usually desired for efficiency reasons to manufacture the required hybrid elements in series of large numbers, stacking the hybrid elements may also require a considerable financial effort.

The object of the present invention is to provide a method for automatically placing components on a base plate, which allows for an economic automated manufacture of circuits containing hybrid elements with high quality.

The object is achieved by a method for automatically placing components such as substrates or circuit components on a base plate of the circuit, based on predefined position data, comprising the following steps:
a) detecting the position of at least one reference mar formed at the base plate;
b) calculating a target position for placing a substrate on the base plate based on the detected position of the first reference mark and the predefined position data for said substrate, and placing the substrate at the calculated position;
c) detecting the position of at least one second reference mark formed at the substrate;
d) calculating a target position for placing the component on the substrate based on the detected position of the second reference mark and the predefined position data for said component, and placing the component at the calculated target position.

The component mentioned in step d) may be a circuit component or a further substrate.

The detection of the position of the at least one first reference mark allows a comparison of the position occupied by the base plate at the placing ma-chine with an expected or ideal position and to take account of it when placing components on the base plate. Thus, inaccuracies of positioning the base plate do not necessarily lead to systematic displacements of the circuit components mounted immediately on the base plate. If one of the components mounted directly or indirectly on the base plate is a substrate which is to serve as a support for further components, the detection of the position of this substrate allows a comparison of its effective position with a position specified by the predefined position data and account to be taken of differences between the two when placing a component on said substrate. Systematic inaccuracies are thus avoided when placing components on the substrates, and the accuracy of placement of these components is just as good as when the concerned substrate had had its components mounted to it separately and had only afterwards been mounted on the circuit board.

If only one reference mark is detected in step a) or step c), this allows a calculation of a displacement between real and expected positions of the base plate at the substrate, respectively, based on the assumption that the orientation of base plate and the substrate, respectively, is correct. If two reference marks are detected, both a displacement and a tilt of the base plate and the substrate, respectively, with respect to the expected position may be calculated and compensated.

In order to fix a component at the surface of the base plate or of the substrate mounted to it, the component is preferably pressed against an adhesive layer applied to the base plate or the substrate, respectively, with a predetermined pressing force and pressing time. The pressing time and force are selected so that the adhesive layer is compressed by the component and provides contact between the component and the substrate on as large as surface as possible without emerging at lateral borders of the component, in particular borders at which a single transition to another component occurs, to an extent that this has an effect on the signal transmission between the components.

In order to achieve this, it is appropriate to define the pressing force and/or time dependent on the shape of the component to be glued. The larger its surface is, the longer will usually be the time which the adhesive layer needs for distributing evenly under the component and which the air that may be trapped in the adhesive layer needs for escaping from said layer.

In order to avoid damaging the components or a substrate on which they are to be placed while placing the components, the component, which is held by the placing machine and is moved in a direction essentially perpendicular to the surface of the substrate, is decelerated before reaching the surface of the substrate.

The knowledge of the position of this surface required for a timely deceleration may be obtained by a controller of the placing machine by direct measurement, for example by optical triangulation of said surface. It may also be calculated from a known height of the base plate and the thickness of the substrate, which is assumed to be known. The height of the base plate may be regarded as a constant property of the placing machine. In order to take account of eventual inaccuracies of placement of the base plate, it may be provided that the position of at least three first reference marks at the base plate are detected in all three directions of space (including the height), and that the height of the substrate at the target position at which the component is to be placed is calculated based on the detected heights of said three first reference marks.

The steps of the method described above may all be carried out at an individual placing machine which successively carries out the placing of one or more substrates on the base plate and or further components to be mounted on the substrates. However, it is also possible to distribute the execution of the method to two (or more) placing machines so that for at least one of the substrates to be placed on the base plate, steps a) and b) are carried out at a first placing machine and steps c) and d) for at least one component to be placed on the relevant substrate are carried out at a second placing machine. In this way, the number of different components that have to be handled by a placing machine can be reduced, so that the path lengths along which a gripper of the placing machine moves between a components store and the base plate may be reduced and the placing frequency may be increased.

Preferably, the predefined position data needed by said at least one placing machine is directly transmitted to the placing machine from a CAD sys-tem.

Further features and advantages of the invention become apparent from the subsequent description of an embodiment referring to the appended drawings.
Fig. 1 is a schematic top view of a placing machine with which the method of the invention can be carried out;
Fig. 2 is a schematic perspective view of a base plate with circuit components placed on it;
Fig. 3 is a flow chart of the placing method of the invention;
Figs. 4A to 4C are diagrams for illustrating the mode of operation of the method; and
Fig. 5 shows sub-steps of steps S6, S 11 of the method of Fig. 3.

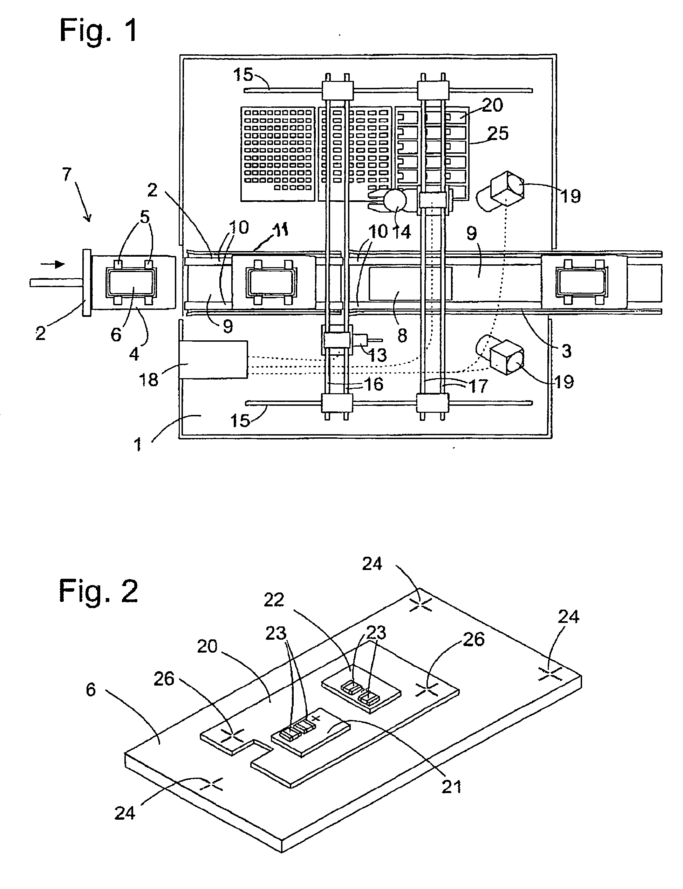

Fig. 1 is a schematic top view of a placing machine with which the method the invention can be carried out. On a vibration-dampened table top 1, the machine comprises two built conveyor devices 2, 3 which are operable for conveying circuit supports 4 on which a base plate 6 on which components are to be mounted is fixed by means of claws 5 from a magazine loader 7 not shown in detail to a placing location 8, and, after placing, out of the placing machine for further processing. The built conveyor devices both have an elongate horizontal plate 9, around which in a lateral region driven belts 10 are slung on which the circuit supports 4 rest, which are to be conveyed. The circuit supports 4 are guided with little clearance between lateral flanks 11.

The placing location 8 is formed by a vertically displaceable table which is inserted into the plate 9 of band conveyor device 3 and which, for placing, is raised against an abutment in order to lift the circuit support 4 of the belts 10 and to bring it to a well defined and reproduceable level.

A dispenser 13 for adhesive and a gripper 14 are displaceable on rails 15 parallel to the conveying direction of built conveyor devices 2, 3 and on rails 16, 17 transverse to the conveying direction. Further, the dispenser 13 and the gripper 14 are vertically displaceable. A control circuit 18 controls the movement of the dispenser 13 and the gripper 14 based on construction data of the circuit to be mounted on the base plate 6. The control circuit 18 is equipped with a digital inter-face and/or a reading device for mobile data carriers for receiving this construction data.

The control circuit 18 is further coupled to two cameras 19 which are held above the table top 1 and are oriented to the placing location 8 from various directions.

Fig. 2 is a perspective view of an example of the base plate 6 with a plurality of components placed there upon, the components comprising substrates 20, 21, 22 and electronic components 23 placed on said substrates. The base plate 6 is provided with three reference marks 24. When the base plate 6 is at the placing location 8, these reference marks 24 are detected by the cameras 19, and the control circuit 18 calculates the position of the reference marks 24 in a coordinate system x, y, z referring to the placing machine, the axes of which are for example selected such that x is aligned with the conveying direction, y with the transverse direction and the horizontal plane and z with the vertical direction.

In a simple embodiment of the method, the control circuit 18 may detect only the x and y coordinates and to assume the z coordinate of the upper side of the base plate 6, on which the components are to be placed, as predefined by the height of the displaceable table at the placing location 8 and the thickness of base plate 6.

To this effect, a simplified embodiment, when com-pared to Fig. 1, of a placing machine might be sufficient that has only one camera 19, which is then preferably directed to the base plate 6 vertically from above. An approximate measurement of the said coordinate of the base plate is also possible using such a camera, applying auto-focus techniques known from photography. In the embodiment of Fig. 1 having two cameras 19, the control circuit 18 can calculate the x, y and z coordinates of the reference marks 24 from the images obtained by the cameras 19 with similar accuracy.

The placing machine of Fig. 1 serves both for applying glue using the dispenser 13 and for placing components of the circuit using the gripper 14, on the applied glue, while base plate 6 is located at the placing location 8. In order to prevent interference of dispenser 13 and gripper 14 while processing a base plate, or in order to increase the throughput of the placing machine, according to an advanced embodiment, not shown, two processing locations connected by belt conveyor means such as 2, 3 are provided, wherein at the first one of these processing locations the dispenser distributes glue on a base plate and simultaneously, at the second processing locations, the gripper is placing components on another base plate.

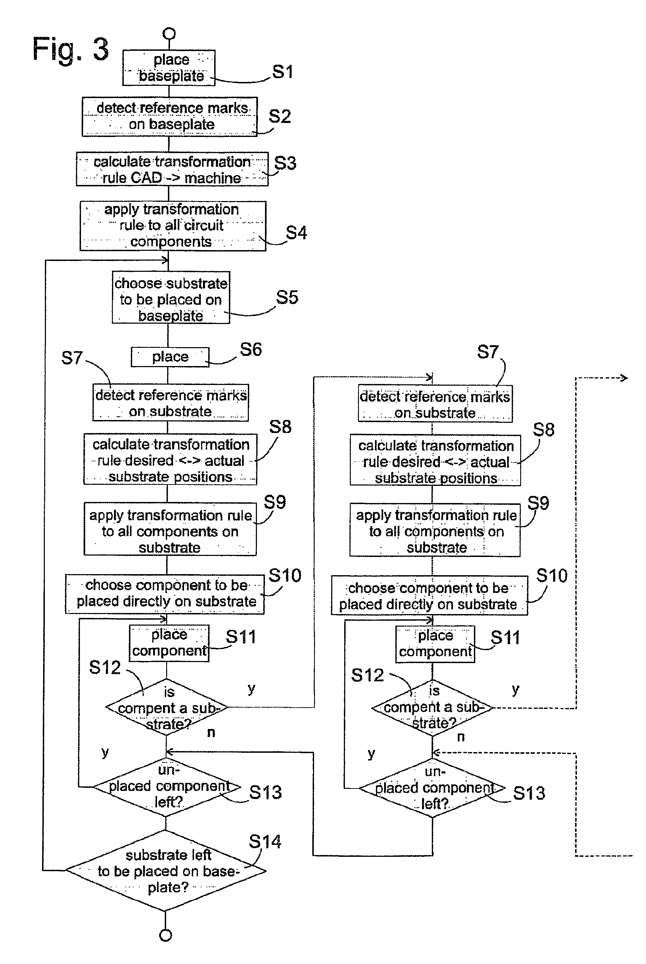

Fig. 3 illustrates the operation of the placing machine of Fig. 1 based on a flow chart. In step S1, the base plate of the circuit to be mounted is brought into position at the placing location 8. In step S2, the cameras 19 detect their reference marks 24 of base plate 1.

The coordinates of the reference marks 24, given in a coordinate system used by the CAD system, are also contained in construction data supplied to the control circuit 18. Based on these coordinates and the coordinates detected in the xyz coordinate system, the control circuit 18 is capable of calculating a transformation rule for converting indications contained in the construction data relating to the position of the components from the a priori unknown coordinate system of the CAD sys-tem into the xyz coordinate system of the placing machine (S3) and to carry out such a conversion (step S4).

In the next step S5, the control circuit 18 selects a substrate to be placed on base plate 6, for example the substrate 20 of the example of Fig. 2. To this effect, the construction data may contain, for each component, an indication about whereupon, on the base plate 6 or a substrate to be placed (directly or indirectly) on the base plate 6 it is to be mounted. However, it is also possible to calculate, based on the indications concerning the shape of the base plate and position and shape of the components contained in the construction data, which of them must be placed immediately on the base plate.

After the substrate 20 has been selected in the data, the control circuit 18 causes the gripper 14 to grip a specimen of this substrate 20 from a component supply 25 and to place it on the base plate 6 according to the indications in the construction data in step S6.

The substrate 20 itself has reference marks 26 which, in step S7, are detected by the control circuit 18. If the placement of the substrate 20 had been absolutely accurate, the detected positions of the reference marks 26 would agree with the theoretical positions specified in the construction data. Based on differences between the measured and the theoretical positions of the reference marks 26, the control circuit 18 calculates a further transformation law in step S8, which transforms the theoretical positions of the reference marks 26 into the measured positions. This transformation law is applied to the position data of all components to be placed directly or indirectly on the substrate 20 in step S9, that is to the substrates 21, 22 and the electronic components 23 located thereupon in the example of Fig. 2.

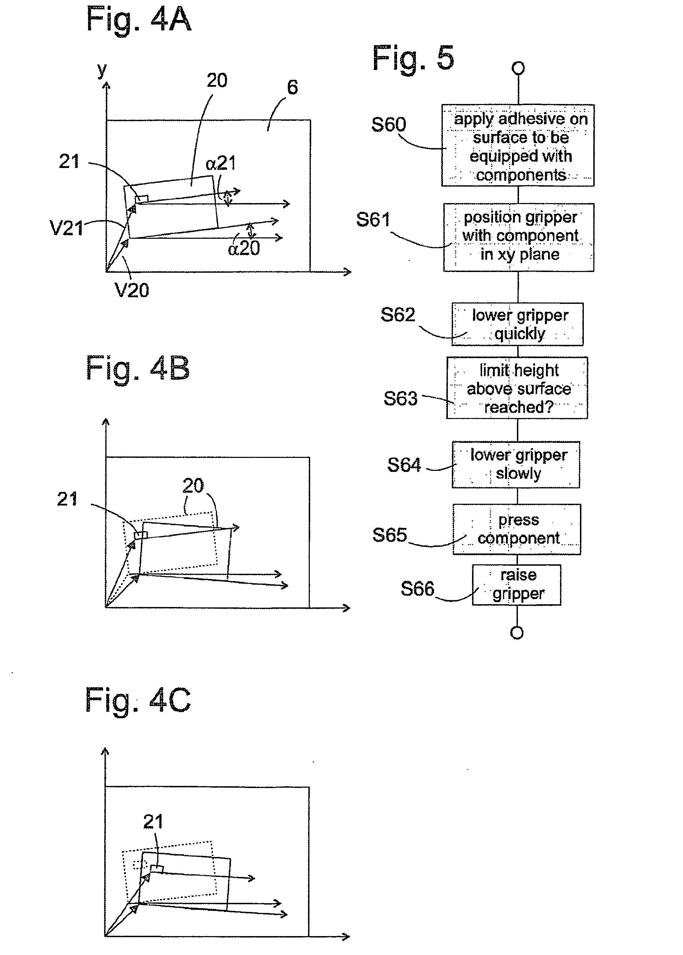

The use of this procedure is illustrated in Figs. 4A to 4C. Vectors V20, V21 indicate the positions of a reference point, here a corner, of the substrates 20, 21, in the xy plane of the xyz coordinate system of the placing machine. The position of the two substrates is completely defined by this vector and an orientation angle α 20 and α 21 respectively.

Fig. 4B shows as a phantom outline the desired position of substrate 20 as specified in the construction data, and - with a highly exaggerated displacement - a real position of the placed substrate 20 as a solid outline. As will be recognized at once, an incorrect position of the substrate 21 on substrate 20 would result if the displacement of the substrate 20 was not taken into account when placing the substrate 21. However, by the transformation of step S9, the position at which the control circuit 18 will mount the substrate 21 is displaced to the position shown in Fig. 4C as a solid outline, so that the substrate 21 is placed correctly with respect to the substrate 20.

After this correction, the control circuit selects, among the circuit components to be placed on the substrate 20, a circuit component, which is to be placed directly on the substrate 20, that is one of the substrates 21, 22 in the case of Fig. 2, and places it in step S11. Since the placed circuit component is a substrate, the procedure branches recursively back from step S12 to step S7, whereby reference marks, this time those of substrate 22, are detected. Again, a transformation law is generated which is now applied to the coordinates of the components to be placed on substrate 21. In the case considered here, these components are two electronic circuit components 23, not substrates, which are placed by twice executing steps S11 to S 13. If there were any substrates among the components to be placed, steps S7 to S13 would have to be repeated at a further recursion level, not shown in Fig. 3.

When the substrate 21 is completely equipped with components, the procedure returns to step S13 of the first recursion level, in which the substrate 22 is placed, and afterwards, steps S7 to S13 are repeated for the electronic components 23 to be placed on it.

When the substrate 20 has thus been completely equipped with components, the control circuit 18 checks in step S14 whether there are any substrates to be placed on base plate 6 left in the construction data. Since this is not a case in the example of Fig. 2, the procedure ends here.

The sub-steps to be carried out when placing a component in steps S6 and S11 are briefly explained referring to the flow chart of Fig. 5.

First, in step S60, adhesive is applied to that portion of the surface of the substrate upon which the component is to be placed. This step may be carried out subsequently for all components to be placed on a substrate, before beginning to place them.

When the gripper 14 has taken a component from a components supply specified by a control circuit 18, it moves to a position in the xy plane above the position specified for the relevant component in the construction data in step S61. In part, this movement may occur simultaneously with a fast downward movement of the gripper in step S61, at least until a height is reached at which no contact with placed circuit components will occur. The height (the said coordinate) of the surface where the circuit component is to be de-posited is known, either by calculation from the positions of reference marks such as 24 or 26 of said surface detected by the cameras 19 or by calculation from the construction data.

When the height becomes less then a threshold height, which depends on the speed of displacement of the gripper (S63), the speed of the gripper is reduced (S64) to prevent a forceful collision between the component held by the gripper and the surface on which it is to be placed. Such a forceful collision could cause damage of the component or an uncontrolled leakage of adhesive from the gap between the component and the surface. The gripper is equipped with a force sensor, to allow detection of the pressure effected upon the component as soon as it comes into contact with the adhesive layer at the surface. This force is set to a value which is specified in the construction data and is predefined depending on the viscosity of the adhesive and the size and shape of the contact surface between the component and the adhesive layer. This value is empirically defined such that the adhesive layer is compressed sufficiently to drive air out of the gap between the component and the surface without causing the adhesive to emerge so far from the sides of the circuit component that it has an effect on the signal transmission of the pressed components or adjacent components, e.g. by rising in a gap between two such components. The pressure is maintained for a short time interval which, taking account of the viscosity properties of the adhesive, is selected to be long enough for elastic tension in the adhesive layer to decay. Thus the component will remain exactly in the position in which it was deposited when the gripper releases it and is raised again.

## Claims

1. A method for automatically placing components (20 to 23) of a circuit on a base plate (6) of the circuit based on predefined position data, comprising the steps of:
a) detecting (S2) the position of at least one reference mark (24) formed at the base plate (6);
b) calculating (S4) a target position for placing a substrate (20) on the base plate (6) based on the detected position of the first reference mark (24) and the predefined position data for said substrate (20) and placing (S6) the substrate (20) at the calculated position;
c) detecting (S7) the position of at least one second reference mark (26) formed at the substrate (20);
d) calculating (S9) a target position for placing a further component (21, 22) on the substrate (20) based on the detected position of the second reference mark (26) and the predefined position data for said component (21, 22), and placing (S 11) the component (21, 22) at the calculated target position.

2. The method of claim 1, **characterized in that** the component (21, 22) is pressed against an adhesive layer applied to said substrate (20) with a predetermined pressing force and/or duration (S65).

3. The method of claim 2, **characterized in that** the pressing force and/or duration is determined depending on the shape of the component (21, 22).

4. The method of claim 2 or 3, **characterized in that** when placing the component (21, 22) it is moved vertically towards the substrate (20) (S62) and is decelerated before reaching the surface of the substrate (S64).

5. The method of any preceding claim, **characterized** that in step d) (S9) the target position of the component is calculated in three spatial directions taking account of the thickness of the substrate (20), and that the component (2122) is decelerated before reaching the height of the thus calculated target position (S64).

6. The method of any preceding claim, **characterized** that in step a) the positions of at least three first reference marks (24) are detected in all three spatial directions (S2), and that the height of the substrate (20) of the target position is calculated based on the detected heights of the three first reference marks (24) (S5).

7. The method of any preceding claim, **characterized in that** the height of the substrate surface is measured at the target position and that the component (21, 22) is decelerated (S64) before reaching the measured height.

8. A method according to any preceding claim, **characterized in that** the steps a) to d) are carried out while the base plate is located at a same placing machine.

9. A method according to any of claims 1 to 7, **characterized in that** the steps a) and b) are carried out at a first placing machine and steps c) and d) are carried out a second placing machine.

10. A method according to any one of the preceding; claims, **characterized in that** the
predefined position data are transferred into all placing machines that carry out the steps a) to d) from a CAD systems.

11. A method according to any preceding claim wherein the components of a circuit are substrates (20 to 22) and/or circuit components (23).

## Patentansprüche

1. Verfahren zum automatischen Platzieren von Bauelementen (20 bis 23) einer Schaltung auf einer Grundplatte (6) der Schaltung auf Grundlage von vorher definierten Positionsdaten, wobei das Verfahren die folgenden Schritte umfasst:
a) Erfassen (S2) der Position von mindestens einer Referenzmarkierung (24), die an der Grundplatte (6) geformt wurde;
b) Berechnen (S4) einer Zielposition zum Platzieren eines Substrats (20) auf der Grundplatte (6) auf Grundlage der erfassten Position der ersten Referenzmarkierung (24) und der vorher definierten Positionsdaten für das Substrat (20) und Platzieren (S6) des Substrats (20) an der berechneten Position;
c) Erfassen (S7) der Position von mindestens einer zweiten Referenzmarkierung (26), die an dem Substrat (20) geformt wurde;
d) Berechnen (S9) einer Zielposition zum Platzieren eines weiteren Bauelements (21, 22) auf dem Substrat (20) auf Grundlage der erfassten Position der zweiten Referenzmarkierung (26) und der vorher definierten Positionsdaten für das Bauelement (21, 22) und Platzieren (S11) des Bauelements (21, 22) an der berechneten Zielposition.

2. Verfahren nach Anspruch 1, **dadurch gekennzeichnet, dass** das Bauelement (21, 22) mit einer vorher bestimmten Druckkraft und/oder -dauer gegen eine Klebstoffschicht, die auf das Substrat (20) aufgebracht wurde, gedrückt wird (S65).

3. Verfahren nach Anspruch 2, **dadurch gekennzeichnet, dass** die Druckkraft und/oder -dauer in Abhängigkeit von der Form des Bauelements (21, 22) bestimmt wird.

4. Verfahren nach Anspruch 2 oder 3, **dadurch gekennzeichnet, dass**, wenn das Bauelement (21, 22) platziert wird, es vertikal in Richtung des Substrats (20) bewegt wird (S62) und abgebremst wird, bevor es die Oberfläche des Substrats erreicht (S64).

5. Verfahren nach einem der vorhergehenden Ansprüche, **dadurch gekennzeichnet, dass** in Schritt d) (S9) die Zielposition des Bauelements in drei Raumrichtungen unter Berücksichtigung der Dicke des Substrats (20) berechnet wird und dass das Bauelement (21, 22) abgebremst wird, bevor es die Höhe der so berechneten Zielposition erreicht (S64).

6. Verfahren nach einem der vorhergehenden Ansprüche, **dadurch gekennzeichnet, dass** in Schritt a) die Positionen von mindestens drei ersten Referenzmarkierungen (24) in allen drei Raumrichtungen erfasst werden (S2) und dass die Höhe des Substrats (20) der Zielposition auf Grundlage der erfassten Höhen der drei ersten Referenzmarkierungen (24) berechnet wird (S9).

7. Verfahren nach einem der vorhergehenden Ansprüche, **dadurch gekennzeichnet, dass** die Höhe der Substratoberfläche an der Zielposition gemessen wird und dass das Bauelement (21, 22) abgebremst wird (S64), bevor es die gemessene Höhe erreicht.

8. Verfahren nach einem der vorhergehenden Ansprüche, **dadurch gekennzeichnet, dass** die Schritte a) bis d) ausgeführt werden, während die Grundplatte sich an einer identischen Bestückungsmaschine befindet.

9. Verfahren nach einem der Ansprüche 1 bis 7, **dadurch gekennzeichnet, dass** die Schritte a) und b) an einer ersten Bestückungsmaschine ausgeführt werden und die Schritte c) und d) an einer zweiten Bestückungsmaschine ausgeführt werden.

10. Verfahren nach einem der vorhergehenden Ansprüche, **dadurch gekennzeichnet, dass** die vorher definierten Positionsdaten von einem CAD-System in alle Bestückungsmaschinen übermittelt werden, die die Schritte a) bis d) ausführen.

11. Verfahren nach einem der vorhergehenden Ansprüche, bei dem es sich bei den Bauelementen einer Schaltung um Substrate (20 bis 22) und/oder Schaltungsbauelemente (23) handelt.

## Revendications

1. Procédé pour placer automatiquement des composants (20 à 23) d'un circuit sur un socle (6) du circuit sur la base de données de position prédéfinies, comprenant les étapes consistant à :
a) détecter (S2) la position d'au moins une marque de référence (24) formée au niveau du socle (6) ;
b) calculer (S4) une position cible pour placer un substrat(20) sur le socle (6) sur la base de la position détectée de la première marque de référence (24) et des données de position prédéfinies pour ledit substrat (20) et placer (S6) le substrat (20) à la position calculée ;
c) détecter (S7) la position d'au moins une seconde marque de référence (26) formée au niveau du substrat (20) ;
d) calculer (S9) une position cible pour placer un composant supplémentaire (21,22) sur le substrat (20) sur la base de la position détectée de la seconde marque de référence (26) et des données de position prédéfinies pour ledit composant (21,22) et placer (S11) le composant (21,22) à la position cible calculée.

2. Procédé selon la revendication 1, **caractérisé en ce que** le composant (21,22) est pressé contre une couche adhésive appliquée sur ledit substrat (20) avec une force et/ou durée de pressage prédéterminée (S65).

3. Procédé selon la revendication 2, **caractérisé en ce que** la force et/ou durée de pressage est déterminée en fonction de la forme du composant (21,22).

4. Procédé selon la revendication 2 ou 3, **caractérisé en ce que**, lors du placement du composant (21,22), il est déplacé verticalement dans la direction du substrat (20) (S62) et est décéléré avant d'atteindre la surface du substrat (S64).

5. Procédé selon une quelconque des revendications précédentes, **caractérisé en ce que** à l'étape d) (S9), la position cible du composant est calculée dans trois directions spatiales en prenant en compte l'épaisseur du substrat (20), et **en ce que** le composant (21,22) est décéléré avant d'atteindre la hauteur de la position cible ainsi calculée (S64).

6. Procédé selon une quelconque des revendications précédentes, **caractérisé en ce que** à l'étape a), les positions d'au moins trois premières marques de référence (24) sont détectées dans toutes les trois directions spatiales (S2), et **en ce que** la hauteur du substrat (20) de la position cible est calculée sur la base des hauteurs détectées des trois premières marques de référence (24) (S9).

7. Procédé selon une des revendications précédentes, **caractérisé en ce que** la hauteur de la surface du substrat est mesurée à la position cible et **en ce que** le composant (21,22) est décéléré (S64) avant d'atteindre la hauteur mesurée.

8. Procédé selon une quelconque des revendications précédentes, **caractérisé en ce que** les étapes a) à d) sont exécutées alors que le socle est situé sur une même machine de placement.

9. Procédé selon une quelconque des revendications 1 à 7, **caractérisé en ce que** les étapes a) et b) sont exécutées sur une première machine de placement et les étapes c) et d) sont exécutées sur une deuxième machine de placement.

10. Procédé selon une quelconque des revendications précédentes, **caractérisé en ce que** des données de position prédéfinies sont transférées à toutes les machines de placement qui exécutent les étapes a) à d) à partir d'un système CAD (dispositif d'acceptation de carte).

11. Procédé selon une quelconque des revendications précédentes, dans lequel les composants d'un circuit sont des substrats (20 à 22) et/ou des composants de circuit (23).
